# EUROPÄISCHE PATENTSCHRIFT

(11) **EP 2 396 535 B1**
(45) Veröffentlichungstag und Bekanntmachung des Hinweises auf die Patenterteilung: **08.04.2015**
(21) Anmeldenummer: 10705137.7
(22) Anmeldetag: 15.02.2010
(51) Int. Cl.: F02M 51/00, F02M 51/06, F02M 63/00, F02M 47/02, H01L 41/053, H01L 41/047

(54) **PIEZOELEKTRISCHER AKTOR, VERFAHREN ZUR HERSTELLUNG DES AKTORS UND INJEKTOR**
PIEZOELECTRIC ACTUATOR, METHOD FOR PRODUCING THE ACTUATOR, AND INJECTOR
ACTIONNEUR PIEZOELECTRIQUE, PROCEDE DE PRODUCTION DE L'ACTIONNEUR ET INJECTEUR

(30) Priorität: 16.02.2009 DE 102009009164
(43) Veröffentlichungstag der Anmeldung: 21.12.2011
(73) Patentinhaber: Continental Automotive GmbH, 30165 Hannover (DE)
(72) Erfinder: UNRUH, Marcus, 93197 Zeitlarn (DE); ZUMSTRULL, Claus, 93128 Regenstauf (DE)
(86) Internationale Anmeldenummer: PCT/EP2010/051846
(87) Internationale Veröffentlichungsnummer: WO 2010/092170

(56) Entgegenhaltungen:
- WO-A1-00/52769
- WO-A1-02/14679
- DE-A1-102005 051 438
- JP-A- 7 226 544

## Beschreibung

### Stand der Technik

Die vorliegende Erfindung betrifft einen piezoelektrischen Aktor nach dem Oberbegriff des Anspruchs 1, ein Verfahren zur Herstellung des Aktors nach dem Oberbegriff des Anspruchs 13 und einen Injektor nach dem Oberbegriff des Anspruchs 14.

Ein solcher Injektor dient insbesondere zur Einspritzung von Brennstoff in eine Brennkraftmaschine, insbesondere einen Dieselmotor, und weist einen piezoelektrischen Aktor mit einem Aktorelement und zwei elektrischen Anschlusselementen auf. Das Aktorelement weist üblicherweise einen Stapel aus mehreren piezoelektrischen Schichten auf, zwischen denen Elektrodenschichten angeordnet sind, welche jeweils elektrisch mit einem der Anschlusselemente verbunden sind. Die zwei Anschlusselemente sind als Drähte ausgebildet, die jeweils mit den Elektrodenschichten verbunden sind und an dem Aktor angelötet sind. Weitere Drähte sind mit weiteren Elektrodenschichten verbunden. Jede zweite Elektrodenschicht ist auf zwei gegenüberliegenden Seiten des Aktorelements jeweils über Drähte mit einem von zwei elektrischen Kontakten verbunden. Die Elektrodenschichten auf der gleichen Seite sind mit dem gleichen elektrischen Kontakt verbunden. An benachbarte Elektrodenschichten können somit jeweils zwei unterschiedliche Spannungen angelegt werden. Das Aktorelement dehnt sich abhängig von den angelegten Spannungen aus oder zieht sich zusammen. Um die gewünschte Kontaktierung der Elektrodenschichten zu ermöglichen, werden auf der einen Seite des Aktors Aussparungen in Randbereichen jeder zweiten Elektrodenschichten entlang des Aktors vorgesehen, und werden auf der anderen Seite des Aktors Aussparungen in Randbereichen der anderen Elektrodenschichten entlang des Aktors vorgesehen. Entlang dieser gegenüberliegenden Bereiche wird jeweils eine Leiterbahn vorgesehen. Diese Leiterbahnen kontaktieren aufgrund der Aussparungen jeweils nur jede zweite Elektrodenschicht. Bei den ausgesparten Bereichen können die piezoelektrischen Schichten daher nicht durch das Anlegen von Spannungen an die Elektrodenschichten verformt werden.

Ein Nachteil eines solchen. Injektors liegt darin, dass sich das Aktorelement aufgrund der Kontaktierung ungleichmäßig verformt, wodurch dessen Wirkungsweise beeinträchtigt wird.

Die WO 00/52769A1 zeigt einen piezoelektrischen Aktor, insbesondere zur Betätigung von Steuerventilen und Einspritzventilen in Kraftfahrzeugen, mit einem Aktorkörper in Form eines vielschichtigen Laminats aus aufeinander geschichteten Lagen piezoelektrischen Materials und dazwischen liegenden metallischen bzw. elektrisch leitenden, als Elektroden dienenden Schichten, die abwechselnd durch an der Mantelseite in Längsrichtung des Aktorkörpers liegende gemeinsame Elektrobahnen kontaktiert sind und mit elektrischen Anschlussleitern, die um den piezoelektrischen Aktor Betriebsspannung zuzuführen, jeweils mit den gemeinsamen Elektrobahnen elektrisch in Kontakt stehen. Der Aktorkörper weist an wenigstens einer der Ventilseite gegenüber liegenden Stirnseite eine Deckschicht aus piezo-inaktivem Keramikmaterial auf, die Anschlussleiter stehen nur im Bereich dieser Deckschicht jeweils mit dem gemeinsamen Elektrobahnen in Kontakt.

### Offenbarung der Erfindung

Der vorliegenden Erfindung liegt die Aufgabe zugrunde, einen Injektor, ein Verfahren zur Herstellung des Injektors und einen piezoelektrischen Aktor zu schaffen, welche eine genaue Kontaktierung der Elektrodenschichten ermöglichen.

Die der Erfindung zugrunde liegende Aufgabe wird durch einen piezoelektrischen Aktor mit den Merkmalen des kennzeichnenden Teils des Patentanspruchs 1, ein Verfahren zur Herstellung eines Aktors mit den Merkmalen des kennzeichnenden Teils des Patentanspruchs 11 und einen Injektor mit dem Merkmalen des kennzeichnenden Teils des Patentanspruchs 12 gelöst.

Die vorliegende Erfindung betrifft einen piezoelektrischen Aktor, wobei zwei Spannbacken vorgesehen sind, zwischen denen das Aktorelement und die Anschlusselemente eingespannt sind, um die elektrischen Anschlusselemente gegen das Aktorelement zu drücken. Dies erlaubt es, die Anschlusselemente auf eine Weise zu verbinden, die eine genaue Positionierung erlaubt.

Für die Kontaktierung kann beispielsweise leitfähiger Klebstoff verwendet werden. Die Spannbacken drücken die Anschlusselemente so lange gegen das Aktorelement, bis der Klebstoff ausgehärtet ist. Nach dem Aushärten des Klebstoffs sind die Spannbacken nicht unbedingt weiter erforderlich. Durch eine Umhüllung des Aktorelements mit einer Füllmasse kann die Befestigung der Anschlusselemente an dem Aktorelement weiter verbessert werden.

Erfindungsgemäß ist eine Feder vorgesehen, um eine der Spannbacken gegen das Aktorelement zu drücken. Eine Feder lässt sich einfach herstellen und während des Zusammenbaus des Aktors handhaben.

Erfindungsgemäß ist eine weitere Feder vorgesehen, um die andere der Spannbacken gegen das Aktorelement zu drücken und das Aktorelement zu zentrieren. Die Verwendung von zwei Spannbacken ermöglicht eine gute Zentrierung des Aktorelements. Zudem ist es für zwei bewegliche Spannbacken leichter möglich als für eine einzige Spannbacke, diese um ein bestimmtes Intervall zu verschieben und gleichzeitig eine hohe Einspannkraft zu erreichen. Dies erleichtert die Positionierung des Aktorelements zwischen den Spannbacken.

In einer bevorzugten Ausführungsform ist eine Halterung vorgesehen, in welcher das Aktorelement aufgenommen ist. An der Halterung können die stromführenden Elemente im festen Abstand zu dem Aktorelement angebracht werden, so dass eine dauerhafte elektrische Kontaktierung des Aktorelements erleichtert wird.

In einer Weiterbildung der letztgenannten Ausführungsform weist die Halterung zwei Kontaktstifte auf, welche mit den Anschlusselementen elektrisch verbunden sind. Die zwei steifen Kontaktstifte lassen sich bei der Herstellung des piezoelektrischen Aktors und dessen Einbau besonders leicht handhaben.

In einer Weiterbildung der letztgenannten bevorzugten Ausführungsform sind die Anschlusselemente biegbar. Die Anschlusselemente können daher nachgeben, wenn sich das Aktorelement verformt, so dass die Anbindungen der Anschlusselemente mit dem Aktor nicht übermäßig beansprucht werden.

In noch einer bevorzugten Ausführungsform weist die Halterung eine Abdeckung auf, an der die Spannbacken befestigt sind. Diese zweiteilige Ausbildung der Halterung erleichtert es, das Aktorelement fest umschlossen in der Halterung aufzunehmen.

In noch einer bevorzugten Ausführungsform ist die Halterung mit einer Füllmasse befüllt. Die Füllmasse sorgt für eine verbesserte Fixierung des Aktorelements und eine verbesserte Befestigung der Anschlusselemente.

In noch einer bevorzugten Ausführungsform ist die die Füllmasse Silikon. Silikon ist besonders geeignet, da es leicht verformbar und elektrisch isolierend ist.

In noch einer bevorzugten Ausführungsform weist das Aktorelement einen aktiven Bereich und einen passiven Bereich auf, und sind die Anschlusselemente an dem passiven Bereich befestigt. Ein aktiver Bereich ist in diesem Zusammenhang ein Bereich des Aktorelements, an den eine Spannung angelegt werden kann und der sich aufgrund der angelegten Spannung verformt. Im Gegensatz hierzu ist ein passiver Bereich in diesem Zusammenhang ein Bereich, an dem keine Spannung angelegt werden kann, oder ein Bereich, der, wenn an diesen eine Spannung angelegt wird, sich aufgrund der angelegten Spannung nicht verformt. Die Anbindung der Anschlusselemente wird somit nicht durch eine ständige Verformung des Aktorelements verschlechtert.

In einer Weiterbildung der letztgenannten bevorzugten Ausführungsform befindet sich der passive Bereich an einem Ende des Aktorelements. Dieses Ende des Aktorelements wird bei der Verwendung so positioniert, dass es sich nicht bewegt. Die Befestigung der Anschlusselemente an dem Aktorelement wird daher nicht durch dessen fortwährende Bewegung belastet.

In noch einer bevorzugten Ausführungsform sind die Elektrodenschichten mit den Anschlusselementen durch elektrisch leitenden Klebstoff verbunden. Im flüssigen Zustand kann der Klebstoff in kleine Löcher fließen, die zur Kontaktierung der Elektrodenschichten dienen. Diese können somit genau kontaktiert werden.

Die vorliegende Erfindung betrifft ferner ein Verfahren zur Herstellung eines Aktors gemäß Anspruch 11, wobei das Aktorelement und die Anschlusselemente zwischen zwei Spannbacken eingespannt werden, um die elektrischen Anschlusselemente gegen das Aktorelement zu drücken. Das Einspannen des Aktorelements und der Anschlusselemente kann auch nur vorübergehend erforderlich sein, da dieses eventuell nur für das Aushärten des Klebstoffs erforderlich ist. Die Entfernung der Spannbacken birgt jedoch das Risiko, dass die Anschlusselemente bei der Entfernung der Spannbacken abreißen, weil die Spannbacken normalerweise auch mit dem Klebstoff in Berührung kommen.

Die vorliegende Erfindung betrifft ferner einen Injektor gemäß Anspruch 12, wobei zwei Spannbacken vorgesehen sind, zwischen denen das Aktorelement und die elektrischen Anschlusselemente eingespannt sind, um die elektrischen Anschlusselemente gegen das Aktorelement zu drücken.

Im Folgenden wird die Erfindung mit Bezugnahme auf die Zeichnungen näher beschrieben. Es zeigen:
FIG. 1A eine Schnittansicht eines Injektors mit einem Aktor in einer geschlossenen Stellung;
FIG. 1B eine Schnittansicht des Injektors in einer geöffneten Stellung;
FIG. 2 eine Schnittansicht des Aktors aus FIG. 1A und FIG. 1B mit einem Aktorelement und einer Abdeckung;
FIG. 3 eine perspektivische Ansicht des Aktorelements aus FIG. 2; und
FIG. 4 eine Vorderansicht der Abdeckung aus FIG. 2.

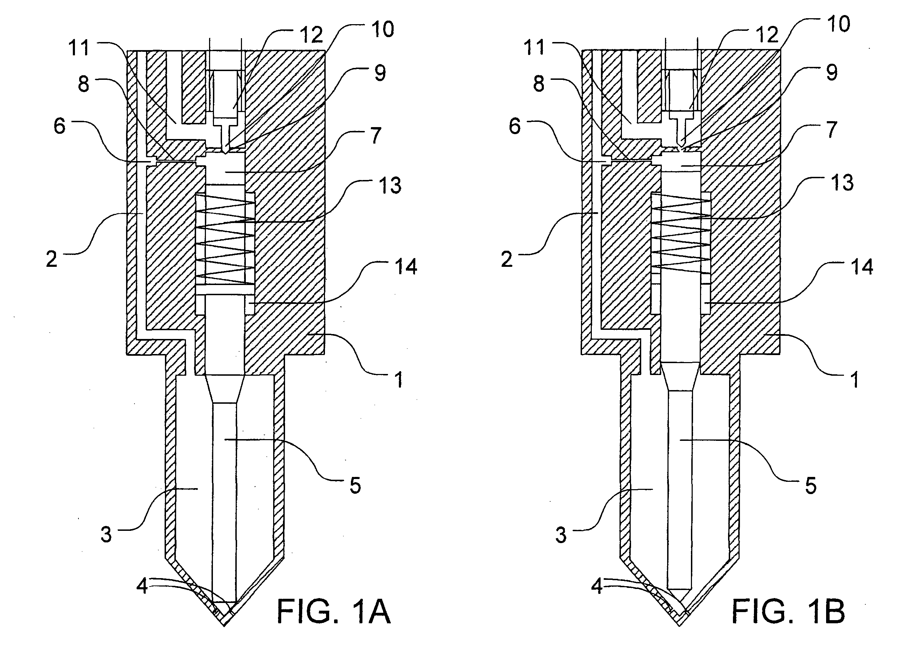

FIG. 1A zeigt eine Schnittansicht eines Injektors mit einem Aktor in einer geschlossenen Stellung. Der Injektor dient dazu Kraftstoff in eine Brennkammer einer Brennkraftmaschine, insbesondere eines Dieselmotors, einzuspritzen. Kraftstoff gelangt durch den Injektorkörper 1 über eine Zuleitung 2 in eine Einspritzkammer 3 am vorderen Ende des Injektors. In die Einspritzkammer 3 münden mehrere Spritzlöcher 4, die in der geschlossenen Stellung durch die Injektornadel 5 verschlossen sind. In die Zuleitung 2 mündet eine weitere Zuleitung 6, die zu einer Steuerkammer 7 führt und in der eine Drossel 8 vorgesehen ist. In der Steuerkammer 7 mündet das verdickte zylindrische Ende der Injektornadel 5. Die Steuerkammer 7 ist über ein Ventil, welche eine Ventilöffnung 9 und einen Ventilstößel 10 aufweist, mit einer Rückleitung 11 verbunden. Die Ventilöffnung 9 ist durch den Ventilstößel 10 verschlossen. Der Ventilstößel 10 wird von einem piezoelektrischen Aktor 12 betätigt, der von der Steuerkammer 7 isoliert ist. Die Injektornadel 5 ist durch eine Feder 13 vorgespannt, die in einem Federaufnahmeraum 14 vorgesehen ist. Die Injektornadel 5 läuft von der Einspritzkammer 3 durch den Federaufnahmeraum 14 zu der Steuerkammer 7. In der Einspritzkammer 3 übt der Kraftstoff eine nach hinten gerichtete Kraft auf die Injektornadel 7 aus. In der Steuerkammer 7 übt der Kraftstoff eine nach vorne gerichtete Kraft auf die Injektornadel 5 aus. Zusätzlich übt die Feder 13 eine nach vorne gerichtete Kraft auf die Injektornadel 5 aus. Die Summe dieser beiden nach vorne gerichteten Kräfte ist größer als die vom Kraftstoff ausgeübte nach hinten gerichtete Kraft, so dass die Injektornadel 5 gegen die Spritzlöcher 4 am vorderen Ende des Injektors gepresst wird, und die Spritzlöcher verschlossen sind.

FIG. 1B zeigt eine Schnittansicht des Injektors in einer geöffneten Stellung. Die Ventilöffnung 9 ist geöffnet. Kraftstoff strömt daher durch die Ventilöffnung 9 und weiter durch die Rückleitung 11. Durch die Drossel 8 kann nur wenig Kraftstoff in die Steuerkammer 7 strömen. Der Druck in der Steuerkammer 7 nimmt ab. Der Druck in der Steuerkammer 7 ist daher geringer als in der geöffneten Stellung. Der Kraftstoff übt folglich eine geringere nach vorne gerichtete Kraft auf die Injektornadel 5 aus. Die Injektornadel 5 befindet sich in einer geöffneten Stellung, in welcher die Summe der vom Kraftstoff ausgeübten nach vorne gerichteten Kraft und der von der Feder 13 ausgeübten nach vorne gerichteten Kraft die vom Kraftstoff ausgeübte nach vorne gerichtete Kraft kompensiert. Die Injektornadel 5 wird nun nicht mehr gegen das vordere Ende des Injektors gepresst und die Spritzlöcher 4 sind geöffnet, so dass der Kraftstoff durch diese in einen Brennraum der Brennkraftmaschine gelangt.

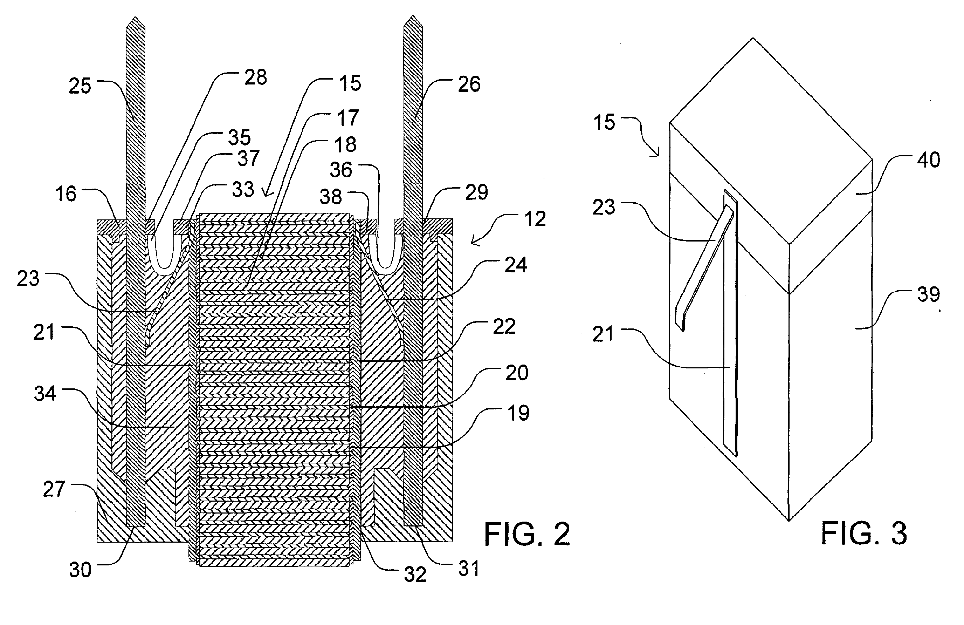

FIG. 2 zeigt eine Schnittansicht des Aktors 12 aus FIG. 1A und FIG. 1B mit einem Aktorelement 15 und einer Abdeckung 16. Das Aktorelement 15 wird durch Sintern hergestellt und weist einen Stapel aus mehreren piezoelektrischen Keramikschichten 17 auf, zwischen denen Elektrodenschichten 18 angeordnet sind. Zur partiellen elektrischen Isolierung der Elektrodenschichten 18 ist an den Seiten des Aktorelements 15 Isolationsfolie 19 vorgesehen. In der Isolationsfolie 19 sind auf zwei gegenüberliegenden Seiten Kontaktlöcher 20 ausgebildet. Auf der Isolationsfolie 19 ist auf jeder der zwei gegenüberliegenden Seiten jeweils eine Leiterbahn 21, 22 aus elektrisch leitendem Klebstoff vorgesehen, der in die Kontaktlöcher 20 gelaufen ist, so dass elektrische Kontakte zwischen den Elektrodenschichten 18 und den elektrischen Leiterbahnen 21, 22 vorhanden sind. Die Kontaktlöcher 20 sind im unteren und mittleren Bereich des Aktorelements 15 auf jeder der zwei Seiten seitlich bei jeder zweiten Elektrodenschicht 18 so vorgesehen, dass die Elektrodenschichten 18 jeweils von genau einer der Leiterbahnen 21, 22 elektrisch kontaktiert werden. Im oberen Bereich des Aktorelements 15 sind keine Kontaktlöcher vorgesehen. An jede der Leiterbahnen 21, 22 ist ein elektrisches Anschlusselement 23, 24 angeklebt, welches mit einem Kontaktstift 25 bzw. 26 aus Metall verbunden ist und aus einem biegbaren Metallband besteht. Das Aktorelement 15 ist in einer Halterung 27 aus Kunststoff aufgenommen, auf welche eine Abdeckung 16 aus Kunststoff aufgesetzt ist. Die Kontaktstifte 25, 26 verlaufen durch Löcher 28, 29 in der Abdeckung 16 und enden in Sacklöchern 30, 31 in dem Boden der Halterung 27. Der Boden der Halterung 27 weist eine zentrale Öffnung 32 auf. Die Abdeckung 16 weist ebenfalls eine zentrale Öffnung 33 auf. Das Aktorelement 12 ist in den zentralen Öffnungen 32, 33 aufgenommen und verläuft durch das Innere der Halterung 27, welches mit Silikon 34 gefüllt ist. Mit der Abdeckung 16 sind Federelemente 35, 36 und Spannbacken 37, 38 einstückig ausgebildet. Die Federelemente 35, 36 pressen jeweils eine der Spannbacken 37, 38 gegen das obere Ende des Aktorelements 12, wo die elektrischen Anschlusselemente 23, 24 mit den Leiterbahnen 21, 22 verbunden sind. Die Spannbacken 37, 38 werden hauptsächlich zur Herstellung des Aktors 12 benötigt.

Zur Herstellung des Aktors 12 werden zunächst das Aktorelement 15 und dann die Kontaktstifte 25, 26 mit den Anschlusselementen 23, 24 in die Halterung 27 eingesetzt. Die Anschlusselemente 23, 24 können so vorgespannt sein, dass sie gegen das Aktorelement 15 drücken. Auf die Halterung 27 wird dann die Abdeckung 16 aufgesetzt, wobei die Federelemente 35, 36 zusammengedrückt werden. Sobald die Abdeckung 16 aufgesetzt ist, werden die Federelemente 35, 36 entspannt und pressen die Spannbacken 37, 38 die elektrischen Anschlusselemente 23, 24 gegen das Aktorelement 15. Dadurch wird eine gute elektrische Verbindung zwischen den Elektrodenschichten 18 des Aktorelements 15 und den Anschlusselementen 23, 24 durch den elektrisch leitfähigen Klebstoff geschaffen, der zu diesem Zeitpunkt noch nicht ausgehärtet ist. Nach dem Aushärten des leitfähigen Klebstoffs wird Silikon durch Vakuumverguss in eine Öffnung der Abdeckung 16 in das Innere der Halterung 27 gefüllt. Diese Öffnung kann beispielsweise ein seitlicher Freiraum in der zentralen Öffnung 33 der Abdeckung 16 sein. Im Inneren der Haltung 27 härtet das Silikon schließlich aus.

Die Halterung und die Abdeckung können auch einstückig ausgebildet sein. Das Aktorelement wird dann in die zentrale Öffnung der Abdeckung eingesetzt.

Bei der Betätigung des Aktors 12 verformen sich beim Anlegen von Spannungen an die Elektrodenschichten 18 die dazwischen liegenden Keramikschichten 17, indem sich etwas ausdehnen. Diese Verformung findet daher nur im mittleren Bereich und im unteren Bereich des Aktorelements 15 statt, wo Kontaktlöcher vorgesehen sind und die Elektrodenschichten 18 elektrisch kontaktiert werden, während im oberen Bereich, wo keine Kontaktlöcher vorgesehen sind und die Elektrodenschichten 18 nicht elektrisch kontaktiert werden, keine Verformung stattfindet. Der Bereich, welcher durch das Anlegen einer Spannung direkt verformt wird, wird als aktiver Bereich 39 bezeichnet, während der Bereich, welcher durch das Anlegen einer Spannung nicht direkt verformt wird, als passiver Be-reich 40 bezeichnet wird (siehe FIG. 3: perspektivische Ansicht des Aktorelements 15 aus FIG. 2). Das Silikon kann der Verformung des Aktorelements 15 folgen und somit einen allmählichen Übergang zu der festen Halterung 27 mit dem Kontaktstiften 25 und 26 schaffen. Eine gleichartige Ausbildung des aktiven Bereichs und des passiven Bereichs erleichtert die Verarbeitung des Aktorelements 15 und fördert dessen Zusammenhalt.

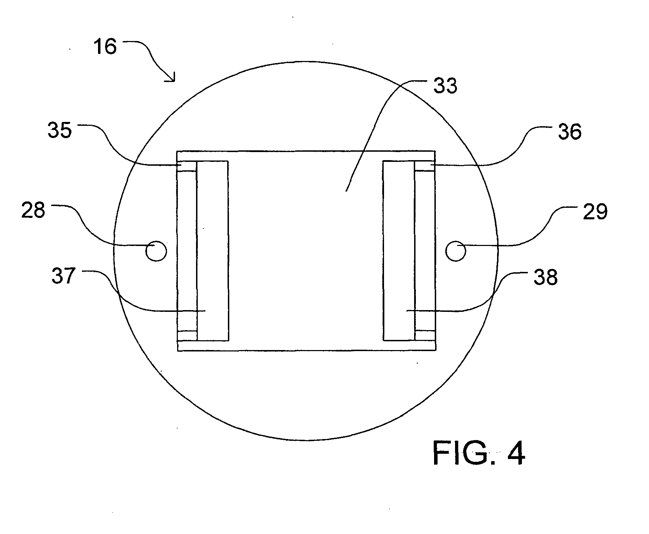

FIG. 4 zeigt eine Vorderansicht der Abdeckung 16 aus FIG. 2. Die Abdeckung 16 ist kreisförmig ausgebildet und an die Form der Halterung angepasst. Die zentrale Öffnung 33 ist viereckig ausgebildet und zwischen den Öffnungen 28 und 29 für die beiden Kontaktstifte angeordnet. Die Spannbacken 37, 38 sind an den gegenüberliegenden Seiten mit zwei Federelementen 35 bzw. 36 mit der Abdeckung 16 verbunden. Im ungespannten Zustand ohne das Aktorelement ragen die Spannbacken 37, 38 weiter in die Öffnung 33 rein als im gespannten Zustand, wenn sich das Aktorelement zwischen den Spannbacken 37, 38 befindet. Die zentrale Öffnung 33 ist soweit ausgebildet, dass das Silikon seitlich zwischen dem Aktorelement und dem Rand der zentralen Öffnung 33 eingefüllt werden kann, wenn sich das Aktorelement in der zentralen Öffnung 33 befindet.

## Patentansprüche

1. Piezoelektrischer Aktor mit einem Aktorelement (15) und zwei elektrischen Anschlusselementen (23, 24), wobei das Aktorelement (15) insbesondere einen Stapel aus mehreren piezoelektrischen Schichten aufweist, zwischen denen Elektrodenschichten angeordnet sind, welche jeweils elektrisch mit einem der Anschlusselemente (23, 24) verbunden sind, **dadurch gekennzeichnet, dass**
a) zwei Spannbacken (37, 38) vorgesehen sind, zwischen denen das Aktorelement (15) und die Anschlusselemente (23, 24) eingespannt sind, um die elektrischen Anschlusselemente (23, 24) gegen das Aktorelement (15) zu drücken,
b) eine Feder (35, 36) vorgesehen ist, um eine der Spannbacken (37, 38) gegen das Aktorelement (15) zu drücken,
c) eine weitere Feder (35, 36) vorgesehen ist, um die andere der Spannbacken (37, 38) gegen das Aktorelement (15) zu drücken und das Aktorelement (15) zu zentrieren.

2. Piezoelektrischer Aktor nach einem der vorhergehenden Ansprüche, **dadurch gekennzeichnet, dass** eine Halterung (27) vorgesehen ist, in welcher das Aktorelement (15) aufgenommen ist.

3. Piezoelektrischer Aktor nach einem der vorhergehenden Ansprüche, **dadurch gekennzeichnet, dass** die Halterung (27) zwei Kontaktstifte aufweist, welche mit den Anschlusselementen (23, 24) elektrisch verbunden sind.

4. Piezoelektrischer Aktor nach Anspruch 3 **dadurch gekennzeichnet, dass** die Anschlusselemente (23, 24) biegbar sind.

5. Piezoelektrischer Aktor nach einem der vorhergehenden Ansprüche, **dadurch gekennzeichnet, dass** die Halterung (27) eine Abdeckung (16) aufweist, an der die Spannbacken (37, 38) befestigt sind.

6. Piezoelektrischer Aktor nach einem der vorhergehenden Ansprüche, **dadurch gekennzeichnet, dass** die Halterung (27) mit einer Füllmasse (34) befüllt ist.

7. Piezoelektrischer Aktor nach Ansprüche 6, **dadurch gekennzeichnet, dass** die Füllmasse Silikon (34) ist.

8. Piezoelektrischer Aktor nach einem der vorhergehenden Ansprüche, **dadurch gekennzeichnet, dass** das Aktorelement (15) einen aktiven Bereich (39) und einen passiven Bereich (40) aufweist, und dass die Anschlusselemente (23, 24) an dem passiven Bereich (40) befestigt sind.

9. Piezoelektrischer Aktor nach Anspruch 8, **dadurch gekennzeichnet, dass** sich der passive Bereich (40) an einem Ende des Aktorelements (15) befindet.

10. Piezoelektrischer Aktor nach einem der vorhergehenden Ansprüche, **dadurch gekennzeichnet, dass** die Elektrodenschichten (18) mit den Anschlusselementen (23, 24) durch elektrisch leitenden Klebstoff (21, 22) verbunden sind.

11. Verfahren zur Herstellung eines piezoelektrischen Aktors (12) mit einem Aktorelement (15) und zwei elektrischen Anschlusselementen (23, 24), wobei das Aktorelement (15) einen Stapel aus mehreren piezoelektrischen Schichten auf-weist, zwischen denen Elektrodenschichten angeordnet sind, welche jeweils elektrisch mit einem der Anschluss elemente (23, 24) verbunden sind, **dadurch gekennzeichnet, dass**
a) das Aktorelement (15) und die Anschlusselemente (23, 24) zwischen zwei Spannbacken (37, 38) eingespannt werden, um die elektrischen Anschlusselemente (23, 24) gegen das Aktorelement (15) zu drücken,
b) eine Feder (35, 36) vorgesehen ist, um eine der Spannbacken (37, 38) gegen das Aktorelement (15) zu drücken,
c) eine weitere Feder (35, 36) vorgesehen ist, um die andere der Spannbacken (37, 38) gegen das Aktorelement (15) zu drücken und das Aktorelement (15) zu zentrieren.

12. Injektor, der einen piezoelektrischen Aktor (12) mit einem Aktorelement (15) und zwei elektrischen Anschlusselementen (23, 24) aufweist, wobei das Aktorelement (15) einen Stapel aus mehreren piezoelektrischen Schichten (17) aufweist, zwischen denen Elektrodenschichten (18) angeordnet sind, welche jeweils elektrisch mit einem der Anschlusselemente (23, 24) verbunden sind, **dadurch gekennzeichnet, dass**
a) zwei Spannbacken (37, 38) vorgesehen sind, zwischen denen das Aktorelement (15) und die Anschlusselemente (23, 24) eingespannt sind, um die elektrischen Anschlusselemente (23, 24) gegen das Aktorelement (15) zu drücken,
b) eine Feder (35, 36) vorgesehen ist, um eine der Spannbacken (37, 38) gegen das Aktorelement (15) zu drücken,
c) eine weitere Feder (35, 36) vorgesehen ist, um die andere der Spannbacken (37, 38) gegen das Aktorelement (15) zu drücken und das Aktorelement (15) zu zentrieren.

## Claims

1. Piezoelectric actuator having an actuator element (15) and two electrical connection elements (23, 24), wherein the actuator element (15) has, in particular, a stack comprising a plurality of piezoelectric layers between which electrode layers are arranged, the said electrode layers each being electrically connected to one of the connection elements (23, 24), **characterized in that**
a) two clamping jaws (37, 38) are provided, the actuator element (15) and the connection elements (23, 24) being clamped between the said clamping jaws in order to press the electrical connection elements (23, 24) against the actuator element (15),
b) a spring (35, 36) is provided in order to press one of the clamping jaws (37, 38) against the actuator element (15),
c) a further spring (35, 36) is provided in order to press the other of the clamping jaws (37, 38) against the actuator element (15) and to centre the actuator element (15).

2. Piezoelectric actuator according to Claim 1, **characterized in that** a holder (27) is provided, the actuator element (15) being accommodated in the said holder.

3. Piezoelectric actuator according to either of the preceding claims, **characterized in that** the holder (27) has two contact pins which are electrically connected to the connection elements (23, 24).

4. Piezoelectric actuator according to Claim 3, **characterized in that** the connection elements (23, 24) can be bent.

5. Piezoelectric actuator according to one of the preceding claims, **characterized in that** the holder (27) has a cover (16) to which the clamping jaws (37, 38) are attached.

6. Piezoelectric actuator according to one of the preceding claims, **characterized in that** the holder (27) is filled with a filling compound (34).

7. Piezoelectric actuator according to Claim 6, **characterized in that** the filling compound is silicone (34).

8. Piezoelectric actuator according to one of the preceding claims, **characterized in that** the actuator element (15) has an active region (39) and a passive region (40), and **in that** the connection elements (23, 24) are attached to the passive region (40).

9. Piezoelectric actuator according to Claim 8, **characterized in that** the passive region (40) is located at one end of the actuator element (15).

10. Piezoelectric actuator according to one of the preceding claims, **characterized in that** the electrode layers (18) are connected to the connection elements (23, 24) by electrically conductive adhesive (21, 22).

11. Method for producing a piezoelectric actuator (12) having an actuator element (15) and two electrical connection elements (23, 24), wherein the actuator element (15) has a stack comprising a plurality of piezoelectric layers between which electrode layers are arranged, the said electrode layers each being electrically connected to one of the connection elements (23, 24), **characterized in that**
a) the actuator element (15) and the connection elements (23, 24) are clamped between two clamping jaws (37, 38) in order to press the electrical connection elements (23, 24) against the actuator element (15),
b) a spring (35, 36) is provided in order to press one of the clamping jaws (37, 38) against the actuator element (15),
c) a further spring (35, 36) is provided in order to press the other of the clamping jaws (37, 38) against the actuator element (15) and to centre the actuator element (15).

12. Injector which has a piezoelectric actuator (12) having an actuator element (15) and two electrical connection elements (23, 24), wherein the actuator element (15) has a stack comprising a plurality of piezoelectric layers (17) between which electrode layers (18) are arranged, the said electrode layers each being electrically connected to one of the connection elements (23, 24), **characterized in that**
a) two clamping jaws (37, 38) are provided, the actuator element (15) and the connection elements (23, 24) being clamped between the said clamping jaws in order to press the electrical connection elements (23, 24) against the actuator element (15),
b) a spring (35, 36) is provided in order to press one of the clamping jaws (37, 38) against the actuator element (15),
c) a further spring (35, 36) is provided in order to press the other of the clamping jaws (37, 38) against the actuator element (15) and to centre the actuator element (15).

## Revendications

1. Actionneur piézo-électrique avec un élément actionneur (15) et deux éléments de connexion électrique (23, 24), l'élément actionneur (15) comprenant plus particulièrement un empilement de plusieurs couches piézo-électriques, entre lesquelles se trouvent des couches d'électrodes, qui sont reliées électriquement avec un des éléments de connexion (23, 24), **caractérisé en ce que**
a) deux mâchoires de serrage (37, 38) sont prévues, entre lesquelles l'élément actionneur (15) et les éléments de connexion (23, 24) sont serrés pour presser les éléments de connexion électrique (23, 24) contre l'élément actionneur (15),
b) un ressort (35, 36) est prévu pour presser une des mâchoires de serrage (37, 38) contre l'élément actionneur (15),
c) un autre ressort (35, 36) est prévu pour presser l'autre mâchoire de serrage (37, 38) contre l'élément actionneur (15) et centrer l'élément actionneur (15).

2. Actionneur piézo-électrique selon l'une des revendications précédentes, **caractérisé en ce qu'**un support (27) est prévu, dans lequel l'élément actionneur (15) est logé.

3. Actionneur piézo-électrique selon l'une des revendications précédentes, **caractérisé en ce que** le support (27) comprend deux broches de contact reliées électriquement avec les éléments de connexion (23, 24).

4. Actionneur piézo-électrique selon la revendication 3, **caractérisé en ce que** les éléments de connexion (23, 24) sont flexibles.

5. Actionneur piézo-électrique selon l'une des revendications précédentes, **caractérisé en ce que** le support (27) comprend une protection (16) sur laquelle les mâchoires de serrage (37, 38) sont fixées.

6. Actionneur piézo-électrique selon l'une des revendications précédentes, **caractérisé en ce que** le support (27) est rempli d'une masse de remplissage (34).

7. Actionneur piézo-électrique selon la revendication 6, **caractérisé en ce que** la masse de remplissage est du silicone (34).

8. Actionneur piézo-électrique selon l'une des revendications précédentes, **caractérisé en ce que** l'élément actionneur (15) comprend une zone active (39) et une zone passive (40) et **en ce que** les éléments de connexion (23, 24) sont fixés sur la zone passive (40).

9. Actionneur piézo-électrique selon la revendication 8, **caractérisé en ce que** la zone passive (40) se trouve au niveau d'une extrémité de l'élément actionneur (15).

10. Actionneur piézo-électrique selon l'une des revendications précédentes, **caractérisé en ce que** les couches d'électrodes (18) sont reliées aux éléments de connexion (23, 24) par l'intermédiaire d'une colle électro-conductrice (21, 22).

11. Procédé de fabrication d'un actionneur piézo-électrique (12) avec un élément actionneur (15) et deux éléments de connexion électrique (23, 24), l'élément actionneur (15) comprenant un empilement de plusieurs couches piézo-électriques entre lesquelles se trouvent des couches d'électrodes qui sont reliées chacune électriquement avec un des éléments de connexion (23, 24), **caractérisé en ce que**
a) l'élément actionneur (15) et les éléments de connexion (23, 24) sont serrés entre deux mâchoires de serrage (37, 38) pour presser les éléments de connexion électrique (23, 24) contre l'élément actionneur (15),
b) un ressort (35, 36) est prévu pour presser une des mâchoires de serrage (37, 38) contre l'élément actionneur (15),
c) un autre ressort (35, 36) est prévu pour presser l'autre mâchoire de serrage (37, 38) contre l'élément actionneur (15) et centrer l'élément actionneur (15).

12. Injecteur comprenant un actionneur piézo-électrique (12) avec un élément actionneur (15) et deux éléments de connexion électrique (23, 24), l'élément actionneur (15) comprenant un empilement de plusieurs couches piézo-électriques (17), entre lesquelles se trouvent des couches d'électrodes (18) reliées chacune électriquement à un des éléments de connexion (23, 24), **caractérisé en ce que**
a) deux mâchoires de serrage (37, 38) sont prévues, entre lesquelles l'élément actionneur (15) et les éléments de connexion (23, 24) sont serrés pour presser les éléments de connexion électrique (23, 24) contre l'élément actionneur (15),
b) un ressort (35, 36) est prévu pour presser une des mâchoires de serrage (37, 38) contre l'élément actionneur (15),
c) un autre ressort (35, 36) est prévu pour presser l'autre mâchoire de serrage (37, 38) contre l'élément actionneur (15) et centrer l'élément actionneur (15).
